# EUROPEAN PATENT APPLICATION

(11) **EP 2 555 333 A1**
(43) Date of publication of application: **06.02.2013**
(21) Application number: 11762628.3
(22) Date of filing: 22.03.2011
(51) Int. Cl.: H01R 12/71, H01R 12/77, H01R 12/78, H01R 12/79

(54) **CONNECTOR**

(30) Priority: 31.03.2010 JP 2010083483
(71) Applicant: Iriso Electronics Co., Ltd., Kanagawa 222-0033 (JP)
(72) Inventor: OHKUMA Yoshihito, Yokohama-shi Kanagawa 222-0033 (JP)
(74) Representative: TBK
(86) International application number: PCT/JP2011/056759
(87) International publication number: WO 2011/122396

(57) **Abstract**

An object of the present invention is to provide a connector which can reduce overall thickness of a substrate including the connector. The connector according to the present invention is configured such that parts of the connector bodies (11 and 21) will be placed in openings (1a) of a substrate (1) and that other parts of the connector bodies (11 and 21), i.e., parts placed on the substrate (1), will be equal in a height dimension to LEDs (2) placed on the substrate (1). This makes it possible to reduce the overall thickness of the substrate (1) including the connector bodies (11 and 21). Consequently, the substrate (1) with the connectors (10 and 20) mounted thereon can be installed without being restricted by substrate installation space even in a small device, such as a thin television set, which has a small substrate installation space in a thickness direction of the substrate (1).

## Description

### Technical Field

The present invention relates to a connector mounted, for example, on edges of LED substrates and used to interconnect the substrates.

### Background Art

Conventionally, in arranging and interconnecting plural substrates such that mounting surfaces of electronic components and the like will be flush with each other, connectors are known which are configured such that a male connector and female connector will be mounted, respectively, on opposite ends of each substrate and that the substrates will be interconnected by fitting the male connector of one substrate into the female connector of another (see, for example, Patent Literature 1).

### Citation List

### Patent Literature

Patent Literature 1: Japanese Utility Model Registration No. 3092610

### Summary of Invention

### Technical Problem

With the conventional connector, since the male or female connector is mounted on the mounting surface of a substrate, the installation location of the substrate requires a space which accommodates the thickness dimension of the substrate plus the height dimension of the connector. In this case, small LEDs approximately 1 mm in height dimension are mounted, for example, on an LED substrate placed in a thin television set, and a sufficient height dimension needs to be secured in a portion where the connector is connected with a mating connector. This makes a connector body larger in height dimension than the LEDs. Consequently, when the connector is mounted on the mounting surface of the substrate, the overall thickness dimension of the substrate including the height dimension of the connector body becomes larger than the overall thickness dimension of the substrate on which only the LEDs are mounted, presenting a problem in that it is difficult to install the LED substrate in a small device, such as a thin television set, which has a small substrate installation space in the thickness direction of the substrate.

The present invention has been made in view of the above problem and has an object to provide a connector which can reduce an overall thickness dimension of a substrate including a height dimension of a connector body.

### Solution to Problem

To achieve the above object, the present invention provide a connector, comprising: a terminal connected at a first end to a mating connector and connected at a second end to a substrate; and a connector body adapted to hold the terminal, wherein that part of the connector body which includes the first end of the terminal is configured to be placeable in an opening provided in an edge of the substrate, and another part of the connector body, that is, a part placed on one surface of the substrate, is sized to be smaller in a thickness direction of the substrate than the part placed in the opening.

Consequently, even when that part of the connector body which includes the first end of the terminal is configured to be larger in thickness dimension than the other part to secure a sufficient height dimension in a connecting portion, if that part of the connector body which includes the first end of the terminal is placed in the opening of the substrate, the overall thickness dimension of the substrate including the connector body can be made smaller than when the entire connector body is put on the substrate.

### Advantageous Effects of Invention

Since the overall thickness dimension of the substrate including the connector body can be made smaller than when the entire connector body is put on the substrate, the present invention allows the substrate with the connector mounted thereon to be installed without being restricted by substrate installation space even in a small device, such as a thin television set, which has a small substrate installation space in a thickness direction of the substrate.

### Brief Description of Drawings

Figure 1 is a top perspective view showing a male connector according to an embodiment of the present invention.
Figure 2 is a bottom perspective view of the male connector.
Figure 3 is a front view of the male connector.
Figure 4 is a plan view of the male connector.
Figure 5 is a side view of the male connector.
Figure 6 is a sectional side view of the male connector.
Figure 7 is a perspective view of a male terminal.
Figure 8 is a top perspective view showing a female connector according to the embodiment of the present invention.
Figure 9 is a bottom perspective view of the female connector.
Figure 10 is a front view of the female connector.
Figure 11 is a plan view of the female connector.
Figure 12 is a side view of the female connector.
Figure 13 is a sectional side view of the female connector.
Figure 14 is a perspective view of a female terminal.
Figure 15 is a perspective view of a locking member.
Figure 16 is a perspective view of principal part of the substrate.
Figure 17 is a perspective view showing how the male connector is mounted on the substrate.
Figure 18 is a perspective view showing how the female connector is mounted on the substrate.
Figure 19 is a perspective view showing how the male connector and female connector are interconnected.
Figure 20 is a perspective view of the connector fitted with a locking member.
Figure 21 is a sectional side view showing how the connectors are connected.
Figure 22 is a plan view of substrates connected by the connector.
Figure 23 is a partial sectional side view of the connector and substrates.
Figure 24 is a top perspective view of a cable-side connector according to another embodiment of the present invention.
Figure 25 is a bottom perspective view of the cable-side connector.
Figure 26 is a side view of the cable-side connector.
Figure 27 is a sectional side view of the cable-side connector.
Figure 28 is a side view of a connector body used for the cable-side connector.
Figure 29 is a perspective view showing how the male connector and cable-side connector are connected.

### Description of Embodiments

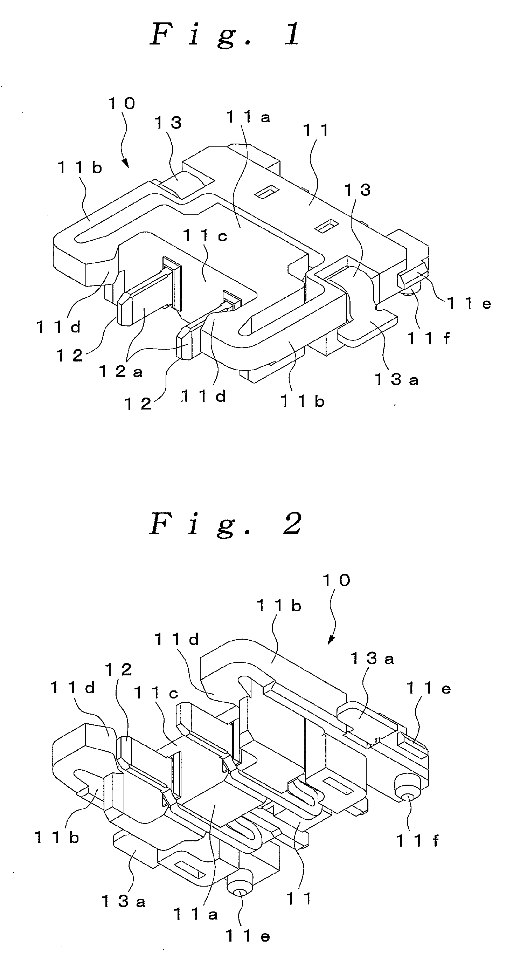

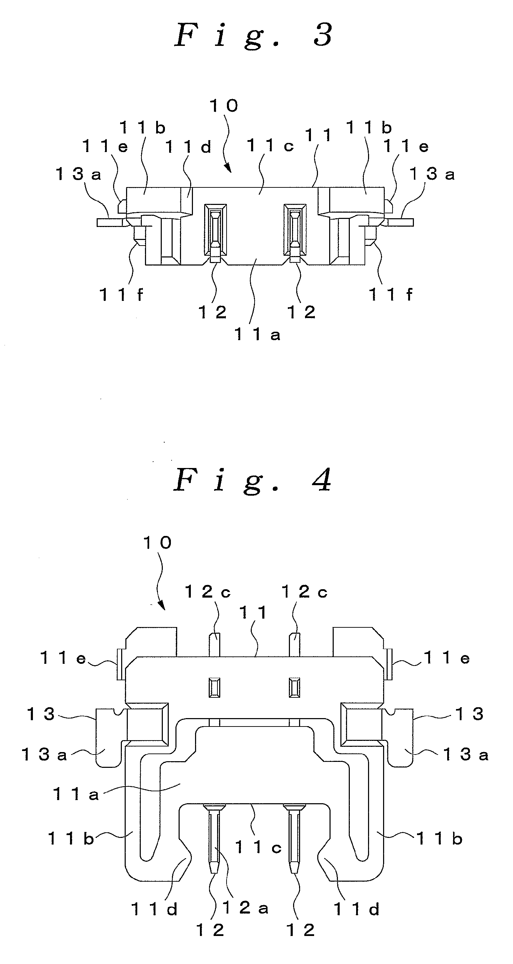

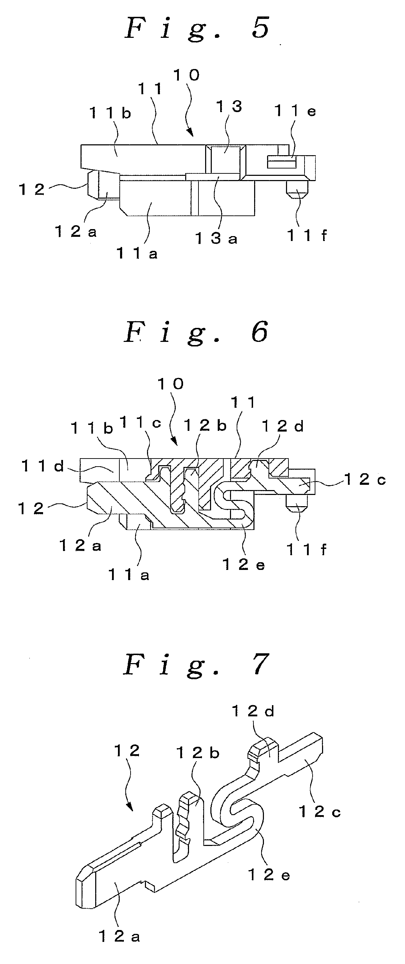

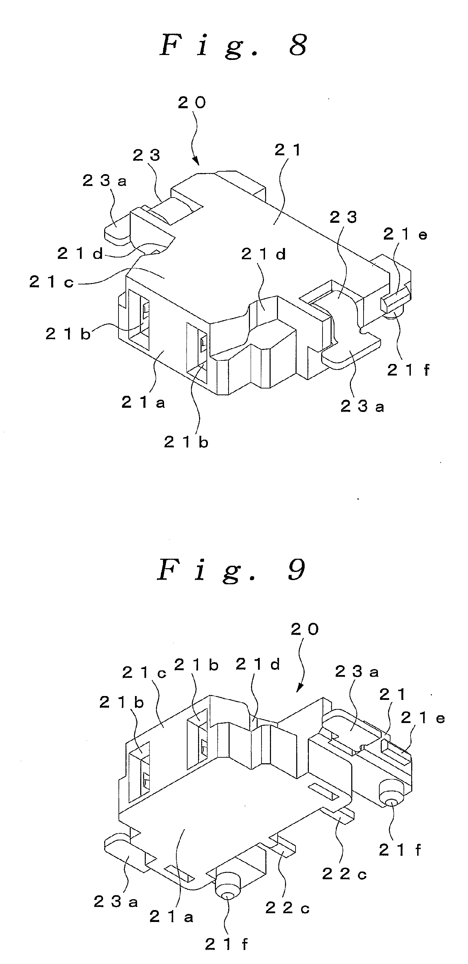

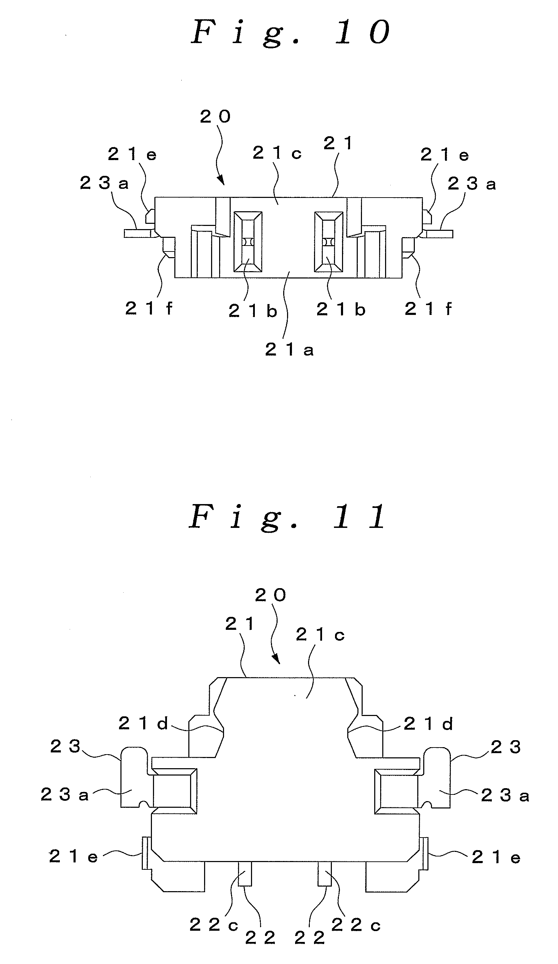

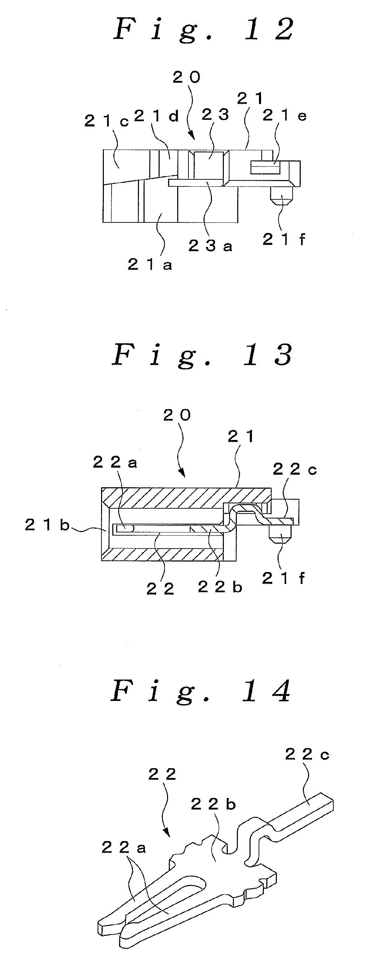

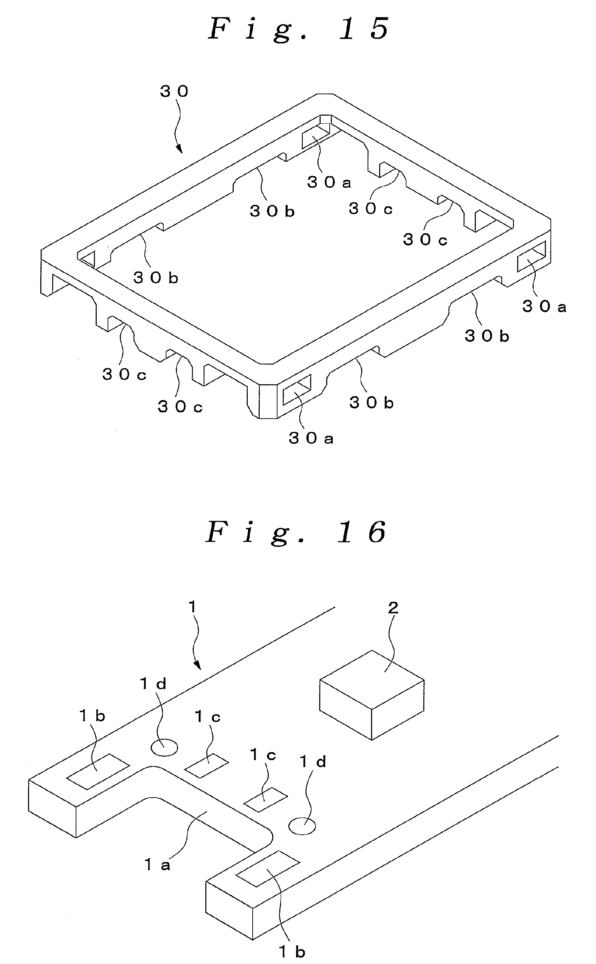

Figures 1 to 23 show an embodiment of the present invention. The connector shown in the figures is used to interconnect plural LED substrates 1 whose component mounting surfaces are placed flush with each other.

Each substrate 1 has the shape of an elongate plate extending in an LED arranging direction. Plural LED_{S} 2 are mounted on a surface (component mounting surface) of the substrate 1 in a thickness direction, being spaced in a longitudinal direction of the substrate 1. An opening 1a (described later) for use to mount the connector is provided on each longitudinal edge of the substrate 1 and connector fasteners 1b made up of metal faces are provided on both sides of each opening 1a in a width direction. Also, a pair of terminal connecting parts 1c to be connected with terminals of the connector are provided in the width direction behind the opening 1a. Each terminal connecting part 1c is electrically continuous to the LEDs 2 via a conductive portion (not shown) provided in the substrate 1. Also, a pair of holes 1d for engagement with the connector are provided in the width direction in the substrate 1.

The connector according to the present embodiment includes a male connector 10 mounted on one of a pair of adjacent substrates 1, a female connector 20 mounted on the other substrate 1, and a locking member 30 adapted to restrain movement of the connector 10 and 20 in a disconnecting direction. The male connector 10 and female connector 20 have the same width dimension.

The male connector 10 includes a connector body 11 which is a molding made of synthetic resin, a pair of terminals 12 held on the connector body 11, and a pair of fastening members 13 mounted on the connector body 11.

A moving part 11a in which first ends of the terminals 12 are placed is provided at a forward end of the connector body 11, being supported on a rear end of the connector body 11 via a pair of elastic parts 11b arranged in the width direction. At the forward end, the moving part 11a has a concave portion 11c in which the female connector 20 is fitted. On both sides of the concave portion 11c in the width direction, a pair of engaging parts 11d adapted to engage with the female connector 20 are arranged in the width direction, protruding to the inside of the concave portion 11c. The elastic parts 11b are formed, extending from the forward end (both sides of the concave portion 11c in the width direction) of the moving part 11a to the rear end of the connector body 11, and the moving part 11a is designed to be able to get displaced in up/down, forward/backward, and width directions relative to the rear end of the connector body 11 due to elastic deformation of the elastic parts 11b. A pair of first projections 11e arranged in the width direction and adapted to engage with the locking member 30 are provided on the rear end of the connector body 11, protruding from opposite flanks of the connector body 11. Also, a pair of second projections 11f arranged in the width direction and adapted to be inserted in the holes 1d in the substrate 1 are provided on the rear end of the connector body 11, protruding from a bottom face of the connector body 11. The connector body 11 is shaped such that the top face will be planar as a whole and that only lower part of the moving part 11a will protrude downward from the bottom face (excluding the second projections 11f). That is, the connector body 11 is shaped such that the lower part of the moving part 11a will be placed in the opening 1a of the substrate 1 and that the other part will be placed on the substrate 1. In this case, that part of the connector body 11 which is placed on the substrate 1 is sized to be equal in height to the LEDs 2 while the moving part 11a is sized to such a height that the lower end will not protrude downward from the bottom face of the substrate 1.

The terminals 12 are each made of a conductive metal plate whose plate thickness direction is configured to correspond to the width direction of the male connector 10. The first ends of the terminals 12 in the forward/backward direction are fixed to the moving part 11a of the connector body 11 while second ends of the terminals 12 are fixed to the rear end of the connector body 11. The first ends of the terminals 12 are each provided with a contact portion 12a coming into contact with the female connector 20 as well as with a first fixing portion 12b press-fitted into the moving part 11a. The contact portions 12a are each formed in a planar shape and shaped so as to protrude into the concave portion 11c of the moving part 11a. The first fixing portions 12b are provided behind the contact portion 12a and shaped so as to protrude upward. The second ends of the terminals 12 are each provided with a connecting part 12c connected with the substrate 1 as well as with a second fixing portion 12d press-fitted into the rear end of the connector body 11. The connecting part 12c is located above lower part of the contact portion 12a and shaped so as to extend rearward. The second fixing portion 12d is provided ahead of the connecting part 12c and shaped so as to protrude upward. An S-shaped elastic part 12e is provided between the first end and second end of each terminal 12, and the first end of the terminal 12 is designed to be able to get displaced in up/down, forward/backward, and width directions relative to the second end due to elastic deformation of the elastic part 12e. In this case, the contact portions 12a, first fixing portions 12b, and elastic parts 12e of the terminals 12 are placed in the moving part 11a of the connector body 11 while the connecting parts 12c and second fixing portions 12d are placed on the rear end of the connector body 11.

The fastening members 13 are each made of a metal plate bent into an inverse U-shape and are placed on both sides of the connector body 11 in the width direction. The fastening members 13 are equipped on first ends with respective joining portions 13a joined to the connector fasteners 1b of the substrate 1 and are mounted on the connector body 11 when second ends are press-fitted into the rear end of the connector body 11.

The female connector 20 includes a connector body 21 which is a molding made of synthetic resin, a pair of terminals 22 held on the connector body 21, and a pair of fastening members 23 mounted on the connector body 21.

A protrusion 21a on which first ends of the terminals 22 are placed is provided at a forward end of the connector body 21, and a pair of insertion holes 21b into which the terminals 12 of the male connector 10 are inserted, respectively, are provided in a front face of the protrusion 21a. At the forward end, the protrusion 21a has a convex portion 21c adapted to fit into the male connector 10. On both sides of the convex portion 21c in the width direction, a pair of engaging parts 21d adapted to engage with the engaging parts 11d of the male connector 10 are arranged in the width direction, each forming a concave shape. A pair of first projections 21e arranged in the width direction and adapted to engage with the locking member 30 are provided on the rear end of the connector body 21, protruding from opposite flanks of the connector body 21. Also, a pair of second projections 21f arranged in the width direction and adapted to be inserted in the holes 1d in the substrate 1 are provided on the rear end of the connector body 21, protruding from a bottom face of the connector body 21. The connector body 21 is shaped such that the top face will be planar as a whole and that only lower part of the protrusion 21a will protrude downward from the bottom face (excluding the second projections 21f). That is, the connector body 21 is shaped such that the lower part of the protrusion 21a will be placed in the opening 1a of the substrate 1 and that the other part will be placed on the substrate 1. In this case, that part of the connector body 21 which is placed on the substrate 1 is sized to be equal in height to the LEDs 2 while the protrusion 21a is sized to such a height that the lower end will not protrude downward from the bottom face of the substrate 1.

The terminals 22 are each made of a conductive metal plate whose plate thickness direction is configured to correspond to the up/down direction of the female connector 20. The first ends of the terminals 22 in the forward/backward direction are fixed to the protrusion 21a of the connector body 21 while second ends of the terminals 22 are fixed to the rear end of the connector body 21. The first ends of the terminals 22 are each provided with a contact portion 22a coming into contact with the male connector 10 as well as with a fixing portion 22b press-fitted into the protrusion 21a. The contact portion 22a is formed in a bifurcated shape, protruding forward, and placed in the protrusion 21a. The fixing portion 22b is provided behind the contact portion 22a and designed to come into pressing contact, on both sides in the width direction, with an inner side of the protrusion 21a. The second ends of the terminals 22 are each provided with a connecting part 22c connected with the substrate 1. The connecting part 22c is bent before the fixing portion 22b so as to be raised above the contact portion 22a.

As with the fastening members 13 of the male connector 10, the fastening members 23 are each made of a metal plate bent into an inverse U-shape and are placed on both sides of the connector body 21 in the width direction. The fastening members 23 are equipped on first ends with respective joining portions 23a joined to the connector fasteners 1b of the substrate 1 and are mounted on the connector body 21 when second ends are press-fitted into the rear end of the connector body 21.

The locking member 30 is formed in the shape of a rectangular frame placed around the respective connector bodies 11 and 21 of the male connector 10 and female connector 20 fitted with each other, surrounding the connector bodies 11 and 21 in the forward/backward and width directions to engage with the connector bodies 11 and 21 from above. In this case, the locking member 30 is sized to be equal in height to those parts of the connector bodies 11 and 21 which are placed on the substrate 1. Plural engaging holes 30a adapted to engage with the first projections 11e and 21e of the respective connector bodies 11 and 21 as well as concave portions 30b adapted to accept the joining portions 13a and 23a of the respective connector 10 and 20 from above are provided on both sides of the locking member 30 in the width direction, where both the engaging holes 30a and concave portions 30b are provided per pair on both front and rear sides. Also, a pair of concave portions 30c adapted to accept the connecting parts 12c and 22c of the respective connector 10 and 20 from above are provided both at the forward end and rear end of the locking member 30, where the concave portions 30c in each pair are arranged in the width direction.

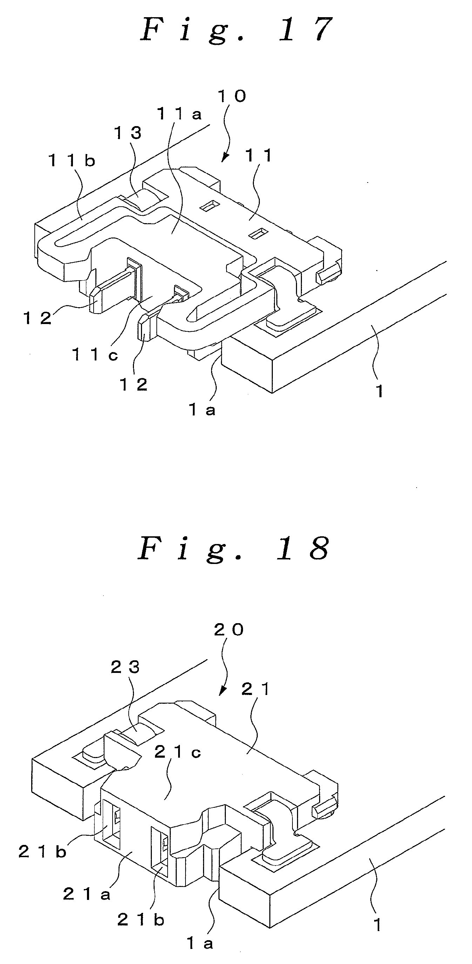

In the connector configured as described above, to mount the male connector 10 on a first of the substrates 1, the male connector 10 is put on the substrate 1 with the lower part of the moving part 11a being placed in the opening 1a of the substrate 1, and then the second projections 11f are inserted in the holes 1d in the substrate 1 and alignment is performed. Next, the joining portions 13a of the fastening members 13 are joined to the connector fasteners 1b of the substrate 1 by soldering and the connecting parts 12c of the terminals 12 are connected to the terminal connecting parts 1c of the substrate 1 by soldering. Consequently, the male connector 10 is mounted on an edge of the first of the substrates 1 as shown in Figure 17. Also, to mount the female connector 20 on a second of the substrates 1, the female connector 20 is put on the substrate 1 with the lower part of the protrusion 21a being placed in the opening 1a of the substrate 1, and then the second projections 21f are inserted in the holes 1d in the substrate 1 and alignment is performed. Next, the joining portions 23a of the fastening members 23 are joined to the connector fasteners 1b of the substrate 1 by soldering and the connecting parts 22c of the terminals 22 are connected to the terminal connecting parts 1c of the substrate 1 by soldering. Consequently, the female connector 20 is mounted on an edge of the second of the substrates 1 as shown in Figure 18.

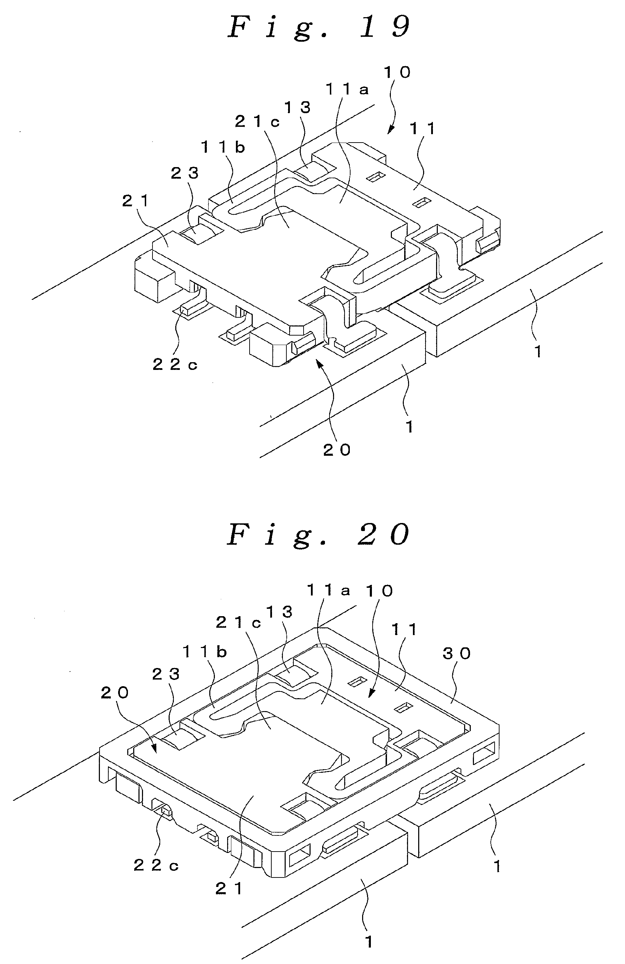

Next, to interconnect the substrates 1, the concave portion 11c of the male connector 10 and convex portion 21c of the female connector 20 are fitted with each other, interconnecting the male connector 10 and female connector 20 on the respective substrates 1 as shown in Figure 19. In so doing, when the convex portion 21c of the female connector 20 is inserted into the concave portion 11c of the male connector 10, the elastic parts 11b of the male connector 10 deform, spacing away from each other in the width direction and thereby causing the engaging parts 11d of the male connector 10 to climb over a tip of the convex portion 21c of the female connector 20 and engage with the engaging parts 21d of the female connector 20. Consequently, the male connector 10 and female connector 20 are locked to each other. Also, when the substrates 1 are interconnected, the contact portions 12a of the terminals 12 of the male connector 10 come into contact with the contact portion 22a of the female connector 20 by being held in the bifurcated contact portion 22a, making the terminals 12 and 22 electrically continuous with each other and thereby interconnecting LED circuits on the substrates 1.

When the respective connector bodies 11 and 21 of the male connector 10 and female connector 20 are fitted in the locking member 30 after being connected with each other, the connector 10 and 20 are locked reliably with their movement in a disconnecting direction restrained as shown in Figure 20. In so doing, when the connector bodies 11 and 21 are placed inside the locking member 30, the first projections 11e and 21e of the respective connector bodies 11 and 21 engage with the engaging holes 30a of the locking member 30, causing the locking member 30 to be held to the connector bodies 11 and 21.

Furthermore, when or after the connector 10 and 20 are interconnected, if the substrates 1 are misaligned with each other, the moving part 11a of the male connector 10 is displaced in up/down, forward/backward, or width direction relative to the rear end of the connector body 11 due to elastic deformation of the elastic parts 11b, absorbing the misalignment between the substrates 1.

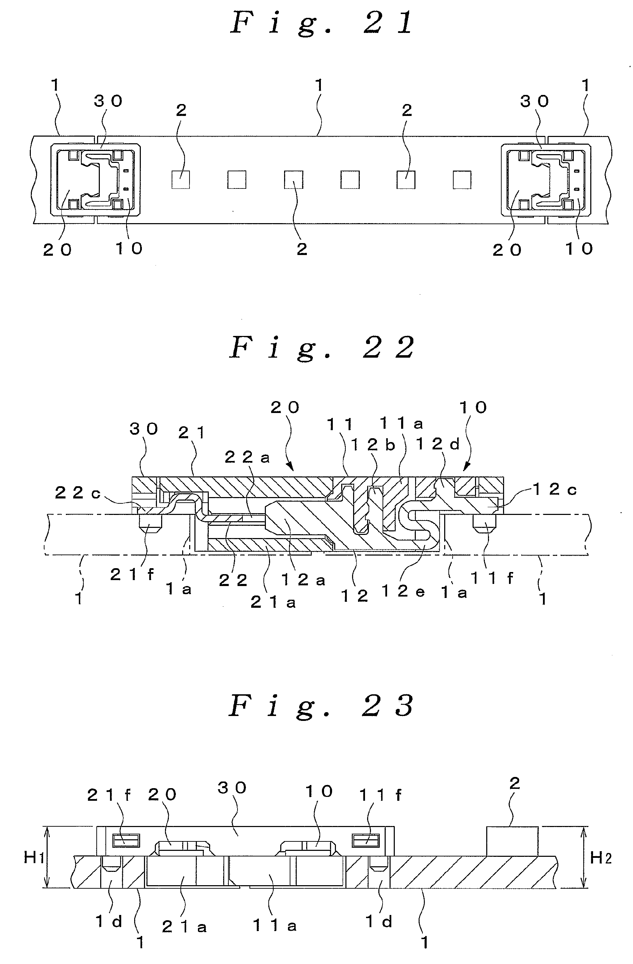

Incidentally, when there or more substrates 1 are interconnected, the male connector 10 and female connector 20 are mounted, respectively, on the two longitudinal edges of each substrate 1 as shown in Figure 22, interconnecting the substrates 1 in series.

As described above, when substrates 1 are interconnected, the male connector 10, female connector 20, and locking member 30 are placed with their top faces being flush with each other. In so doing, the moving part 11a and protrusion 21a of the connector 10 and 20, respectively, are configured to be larger in thickness dimension than the other part to secure a sufficient height dimension in a connecting portion, but since the lower parts of the moving part 11a and protrusion 21a are placed in the openings 1a of the respective substrates 1 and the other part placed on the substrates 1 is sized to be equal in height to the LEDs 2, the overall thickness dimension H1 of the substrates 1 including the connector bodies 11 and 21 and locking member 30 of the connector 10 and 20 does not exceed the total thickness dimension H2 of the substrates 1 and the LEDs 2 as shown in Figure 23.

In this way, with the connector according to the present embodiment, since those parts (lower parts of the moving part 11a and protrusion 21a) of the connector bodies 11 and 21 which include the first ends of the terminals 12 and 22 are placed in the openings 1a of the substrates 1 and the other parts of the connector bodies 11 and 21 placed on one surface of the substrates 1 are sized to be smaller in the thickness direction of the substrates 1 than the parts placed in the openings 1a, the overall thickness dimension H1 of the substrates 1 including the connector bodies 11 and 21 does not exceed the total thickness dimension H2 of the substrates 1 and the LEDs 2. This allows the substrates 1 with the connector 10 and 20 mounted thereon to be installed without being restricted by substrate installation space even in a small device, such as a thin television set, which has a small substrate installation space in the thickness direction of the substrates 1.

Also, since the connector body 11 and terminals 12 of the male connector 10 are configured to be able to get displaced in up/down, forward/backward, and width directions relative to the portion (rear end of the connector body 11) in which the part (moving part 11a) placed in the opening 1a is fixed to the substrate 1, even if the substrates 1 are misaligned with each other, the misalignment between the substrates 1 can be absorbed, making it possible to effectively prevent detachment of the connector fasteners and breakage of the connector due to the misalignment.

In this case, although the elastic parts 12e of the terminals 12 have an increased vertical dimension (in the thickness direction of the connector body 11), being formed in an S shape capable of being displaced in an up/down direction, since the elastic parts 12e are placed in the moving part 11a of the connector body 11, the moving part 11a having a large thickness dimension, even though the elastic parts 12e are increased in the vertical dimension, the elastic parts 12e can be contained in the connector body 11.

Furthermore, since the connector bodies 11 and 21 are provided with the engaging parts 11d and 21d which restrain movement of the connector 10 and 20 in the disconnecting direction by getting engaged with each other, there is the advantage of being able to lock the connector bodies 11 and 21 fitted with each other, thereby preventing the connector 10 and 20 from being disconnected easily. In this case, since the engaging parts 11d of the male connector 10 climbs over the convex portion 21c of the female connector 20 by producing elastic deformation of the elastic parts 11b and thereby engages with the engaging parts 21d of the female connector 20, a feel of the engagement between the engaging parts 11d and 21d is provided reliably by resilience of the elastic parts 11b, making it possible to effectively prevent a bad connection due to incomplete insertion. Also, since both a function to permit displacement of the moving part 11a in order to absorb misalignment between the substrates 1 and a function to permit displacement of the engaging parts 11d when the engaging parts 11d and 21d are engaged can be achieved by the elastic deformation of the elastic parts 11b, the connector body 11 provided with these functions can be made compact.

Also, since the movement of the connector bodies 11 and 21 in the disconnecting direction is restrained by the locking member 30 fitted over the respective connector bodies 11 and 21 of the interconnected male connector 10 and female connector 20, the connector bodies 11 and 21 can be locked reliably in a state of being fitted with each other. This makes it possible to more effectively prevent the connector 10 and 20 from being disconnected.

In this case, since the locking member 30 is configured with a frame-like member placed around the respective connector bodies 11 and 21 of the male connector 10 and female connector 20, the connector bodies 11 and 21 can be constrained reliably in a state of being fitted with each other and the locking member 30 can be made no larger in the height dimension than the connector bodies 11 and 21. This is extremely advantageous in size reduction of the connector 10 and 20 in the height direction.

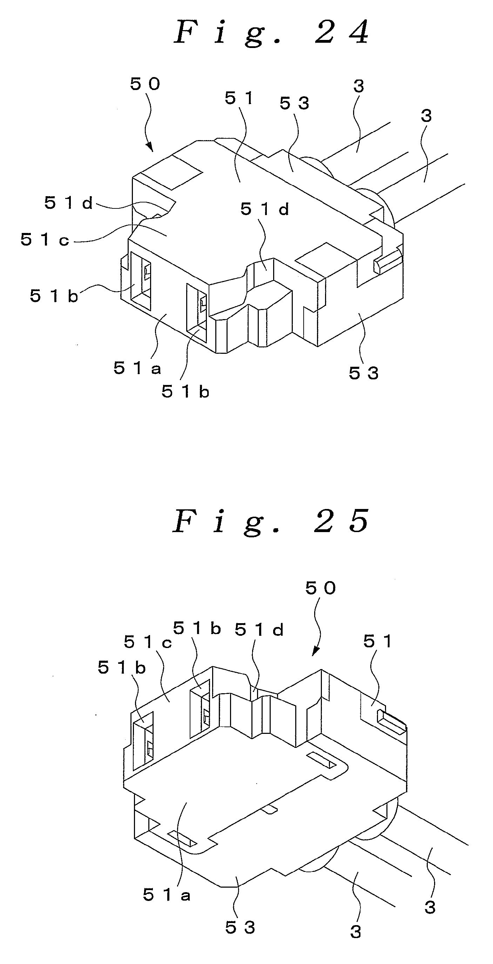

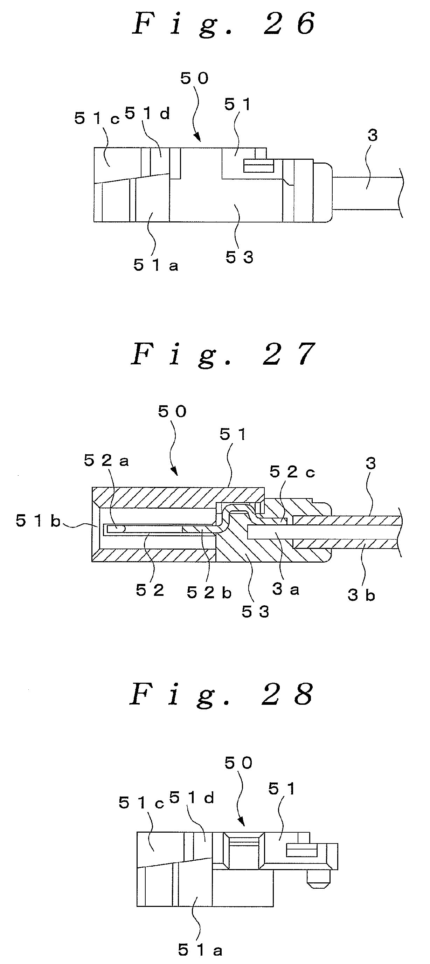

Figures 24 to 29 show another embodiment of the present invention. The connector shown in the figures is used to connect a power supply cable 3 to a substrate 1 placed at the tail end out of plural LED substrates 1 whose component mounting surfaces are placed flush with each other. Incidentally, components equivalent to those of the above-described embodiment are denoted by the same reference numerals as the corresponding components of the above-described embodiment.

The connector according to the present embodiment includes a substrate-side connector 40 mounted on one edge of the substrate 1 in the longitudinal direction and a cable-side connector 50 attached to first ends of a set of two cables 3. Incidentally, the substrate-side connector 40 has a configuration equivalent to that of the male connector 10 according to the above-described embodiment, and thus description of the configuration will be omitted.

The cables 3, made up of two wires configured by covering conductors 3a with respective sheaths 3b, are used to supply electric power to the LEDs 2 on the substrate 1 from a power supply (not shown).

Since the configuration of the substrate-side connector 40 is equivalent to that of the male connector 10 according to the above-described embodiment, detailed description thereof will be omitted. That is, the substrate-side connector 40 includes a connector body 41, a pair of terminals (not shown), and fastening members 42, similar to those of the male connector 10 according to the above-described embodiment.

The cable-side connector 50 includes a connector body 51 which is a molding made of synthetic resin, a pair of terminals 52 held on the connector body 11, and a cable holder 53 provided integrally with the connector body 51, where some of the components are the same as those (connector body 21 and terminals 22) of the female connector 20 according to the above-described embodiment. Incidentally, since configurations of the connector body 51 and terminals 52 of the cable-side connector 50 are equivalent to those of the connector body 21 and terminals 22 according to the above-described embodiment, detailed description thereof will be omitted.

The connector body 51 includes a protrusion 51a, insertion holes 51b, a convex portion 51c, and engaging parts 51d, similar to those of the above-described embodiment, but the fastening members 23 of the above-described embodiment are not mounted.

Each of the terminals 52 includes a contact portion 52a, a fixing portion 52b, and a connecting part 52c, similar to those of the above-described embodiment, where the connecting parts 52c are connected with the conductors 3a of the cables 3 with the sheaths 3b removed from tips of the conductors 3a.

The cable holder 53 is made of a molding of synthetic resin and formed integrally with the rear end of the connector body 51 by insert molding. That is, the cable holder 53 is provided integrally with the connector body 51, covering first ends of the cable 3 connected to the terminals 52, and a top face, a bottom face, and opposite flanks of the cable holder 53 are formed to be flush with a top face, a bottom face, and opposite flanks of the connector body 51.

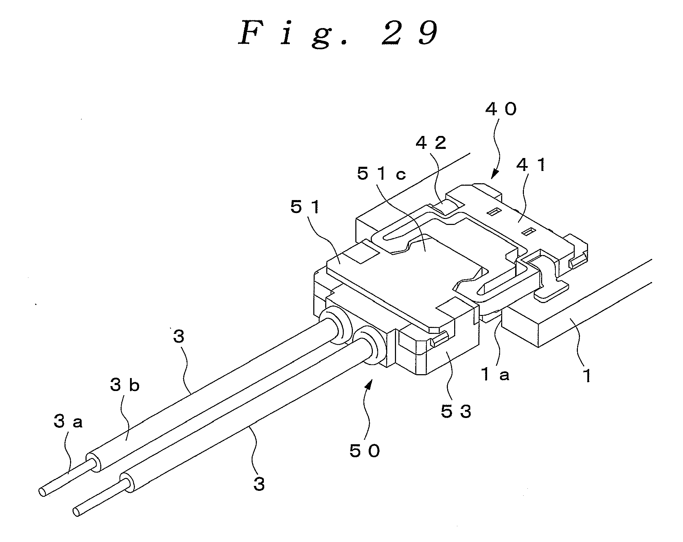

In the connector configured as described above, as with the above-described embodiment, the substrate-side connector 40 is mounted on the substrate 1, and connected with the cable-side connector 50 as shown in Figure 29. Consequently, the terminals of the substrate-side connector 40 come into contact with the terminals 42 of the cable-side connector 50 and the cables 3 are connected to a LED circuit on the substrate 1.

In this way, with the connector according to the present embodiment, since the cable-side connector 50 connected to the substrate-side connector 40 mounted on the substrate 1 is configured from some (connector body 21 and terminals 22) of the components of the female connector 20 according to the above-described embodiment, components can be shared with the female connector 20 which has a similar mating connector, making it possible to manufacture the cable-side connector 50 easily.

In this case, as with the male connector 10 according to the above-described embodiment, the substrate-side connector 40 is configured as follows: part of the connector body 41 is placed in the opening 1a of the substrate 1 while the other part of the connector body 41, i.e., the part placed on the substrate 1, is sized to be smaller in the thickness direction of the substrate 1 than the part placed in the opening 1a. Also, the cable-side connector 50 is sized to be similar in height to the female connector according to the above-described embodiment. Consequently, as with the above-described embodiment, the overall thickness dimension of the substrate 1 including the connector bodies 41 and 51 does not exceed the total thickness dimension of the substrate 1 and the LEDs 2. This allows the substrate 1 with the connector 40 and 50 mounted thereon to be installed without being restricted by substrate installation space.

Besides, although the female connector, which undergoes deformation of the terminals when pulled out, is generally more prone to breakage than the male connector, since the cable-side connector 50 according to the present embodiment is configured as a female connector, the cable-side connector 50 is more easy to replace than the substrate-side connector 40 (male connector) mounted on the substrate 1 and readily lends itself to a replacement operation in case of breakage.

Incidentally, although in the present embodiment, the cable-side connector 50 is configured as a female connector to allow for ease of replacement in case of breakage, the cable-side connector 50 may be configured from some of the components of the male connector 10 according to the above-described embodiment.

Also, although in the present embodiment, the cable holder 53 is formed integrally with the connector body 51 by insert molding, the cable holder may be formed as a discrete component separately from the connector body 51 and fitted in the connector body 51.

Furthermore, although in the embodiments described above, the connector is intended for LED substrates, the present invention is also applicable to connectors for substrates other than LED substrates.

### Reference Signs List

1: substrate; 1a: opening; 2: LED; 3: cable; 10: male connector; 11: connector body; 11a: moving part; 11d: engaging part; 12: terminal; 20: female connector; 21: connector body; 21a: moving part; 21d: engaging part; 22: terminal; 30: locking member; 40: male connector; 41: connector body; 50: cable-side connector; 51: connector body; 52: terminal.

## Claims

1. A connector, comprising:
a terminal connected at a first end to a mating connector and connected at a second end to a substrate; and
a connector body adapted to hold the terminal,
wherein that part of the connector body which includes the first end of the terminal is configured to be placeable in an opening provided in an edge of the substrate, and
another part of the connector body, that is, a part placed on one surface of the substrate, is sized to be smaller in a thickness direction of the substrate than the part placed in the opening of the substrate.

2. The connector according to claim 1, wherein the connector body is configured such that the part placed in the opening of the substrate does not protrude from another surface of the substrate.

3. The connector according to claim 1, wherein the connector body and the terminal are configured such that the part placed in the opening of the substrate are able to get displaced in a predetermined direction relative to a part fixed to the substrate.

4. The connector according to claim 3, wherein:
an elastic part elastically deformable at least in the thickness direction of the substrate is provided between the first end and second end of the terminal; and
the elastic part is placed in that part of the connector body which is placed in the opening of the substrate.

5. The connector according to claim 1, wherein the connector body includes an engaging part adapted to engage with the mating connector and restrain movement of the connector body in a disconnecting direction.

6. A connector which connects a pair of substrates placed so as to be flush with each other on one plane in a thickness direction, the connector comprising:
a male connector mounted on one of the substrates; and a female connector mounted on another of the substrates, wherein
the male connector and the female connector are configured with the connector according to claim 1.

7. The connector according to claim 6, further comprising a locking member adapted to restrain movement of respective connector bodies of the interconnected male connector and female connector in a disconnecting direction when fitted on the connector bodies.

8. The connector according to claim 7, wherein the locking member is configured with a frame-like member placed around the respective connector bodies of the male connector and the female connector.

9. A connector used to connect a cable to a substrate, the connector comprising:
a substrate-side connector mounted on a substrate; and
a cable-side connector mounted on one end of a cable,
wherein the substrate-side connector is configured with the connector according to claim 1, and
the cable-side connector is formed using at least some of components of the connector according to claim 1.

10. The connector according to claim 9, wherein the substrate-side connector is configured with a male connector and the cable-side connector is configured with a female connector.
